# EUROPEAN PATENT APPLICATION

(11) **EP 4 206 696 A1**
(43) Date of publication of application: **05.07.2023**
(21) Application number: 21861254.7
(22) Date of filing: 12.08.2021
(51) Int. Cl.: G01R 29/10, G01R 31/26

(54) **INSPECTION DEVICE**

(30) Priority: 27.08.2020 JP 2020143159
(71) Applicant: YOKOWO CO., LTD., Kita-ku Tokyo 114-8515 (JP)
(72) Inventor: NOGUCHI Masaki, Tomioka-Shi, Gunma 370-2495 (JP)
(74) Representative: Gunzelmann, Rainer
(86) International application number: PCT/JP2021/029731
(87) International publication number: WO 2022/044826

(57) **Abstract**

An inspection device (10) includes a fixing portion (200) fixing a semiconductor device (500) being a DUT and an antenna portion (30) inspecting the semiconductor device (500). The fixing portion (200) defines a hole (210) exposing at least a portion of the semiconductor device (500). At least a portion of the inside surface of the hole (210) in the fixing portion (200) includes a step portion.

## Description

### TECHNICAL FIELD

The present invention relates to an inspection device.

### BACKGROUND ART

In recent years, various inspection devices for inspecting a semiconductor device including an antenna have been developed. For example, an inspection device as described in Patent Document 1 includes a holding portion holding a semiconductor device being a device under test (DUT), and an antenna portion inspecting the DUT. The holding portion includes a fixing portion fixing the DUT. The fixing portion defines a hole exposing at least a portion of the DUT.

### RELATED DOCUMENT

### PATENT DOCUMENT

Patent Document 1: International Application Publication No. WO 2014/136159

### SUMMARY OF THE INVENTION

### TECHNICAL PROBLEM

Some of the radio waves emitted from the DUT may be scattered by the fixing portion. In this case, when the inside surface of the hole formed in the fixing portion is flat, distortion of an emission pattern of the radio waves of the DUT may occur.

An example of an object of the present invention is to reduce distortion of an emission pattern of radio waves of a DUT. Other objects of the present invention will become apparent from the description herein.

### SOLUTION TO PROBLEM

An aspect of the present invention is an inspection device including:
a fixing portion fixing a device under test; and
an antenna portion inspecting the device under test, wherein
the fixing portion defines a hole exposing at least a portion of the device under test, and
at least a portion of an inside surface of the hole in the fixing portion includes a step portion.

### ADVANTAGEOUS EFFECTS OF INVENTION

The aforementioned aspect of the present invention enables reduction in distortion of an emission pattern of radio waves of the DUT.

### BRIEF DESCRIPTION OF THE DRAWINGS

Fig. 1 is a cross-sectional view of an inspection device according to an embodiment.
Fig. 2 is a perspective view of the upper surface of a holding portion according to the embodiment.
Fig. 3 is a perspective view of the upper surface of a semiconductor device.
Fig. 4 is a diagram for illustrating details of an example of a staircase shape of the inside surface of a hole in a fixing portion.
Fig. 5 is a cross-sectional view of an inspection device according to a comparative example.
Fig. 6 is a diagram illustrating an emission pattern of radio waves of a semiconductor device in the inspection device according to the embodiment.
Fig. 7 is a diagram illustrating an emission pattern of radio waves of a semiconductor device in the inspection device according to the comparative example.

### DESCRIPTION OF EMBODIMENTS

An embodiment of the present invention will be described below by using drawings. Note that in every drawing, similar components are given similar signs, and description thereof is omitted as appropriate.

Unless otherwise noted, ordinal numerals such as "first," "second," and "third" are herein given for simply distinguishing between components given with similar names and do not mean a specific characteristic (for example, an order or importance).

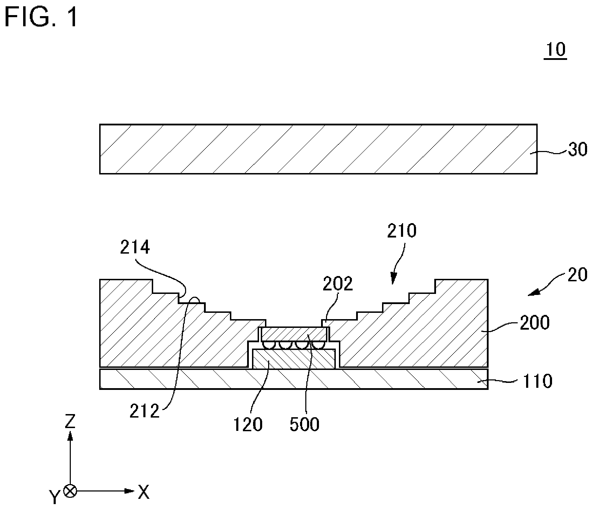

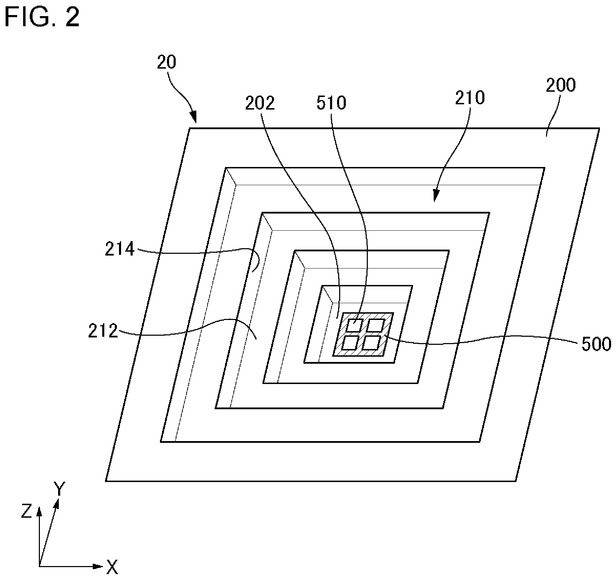

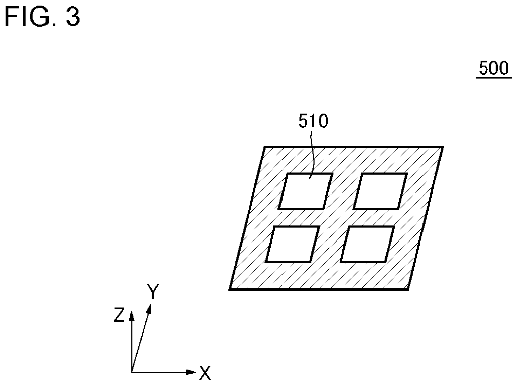

Fig. 1 is a cross-sectional view of an inspection device 10 according to the embodiment. Fig. 2 is a perspective view of the upper surface of a holding portion 20 according to the embodiment. Fig. 3 is a perspective view of the upper surface of a semiconductor device 500.

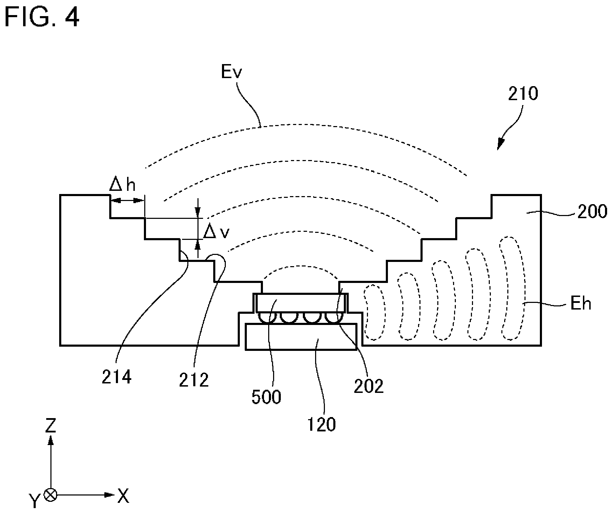

In Fig. 1 to Fig. 3, the direction of an arrow indicating a first direction X, a second direction Y, or a third direction Z indicates a positive direction of the direction indicated by the arrow. On the other hand, the opposite direction of the arrow indicating the first direction X, the second direction Y, or the third direction Z indicates a negative direction of the direction indicated by the arrow. A white circle with an X indicating the second direction Y indicates that the positive direction of the direction indicated by the white circle with the X is a direction from the front to the back of the page, and the negative direction of the direction indicated by the white circle with the X is a direction from the back to the front of the page. The same applies to Fig. 4 to Fig. 7 to be described later.

The first direction X is a direction parallel to a horizontal direction, that is, a direction orthogonal to a vertical direction. Specifically, the first direction X is a direction parallel to one side of a substantially square semiconductor device 500 to be described later. The second direction Y is a direction parallel to the horizontal direction and orthogonal to the first direction X. Specifically, the second direction Y is a direction parallel to the other side of the semiconductor device 500 orthogonal to the above one side parallel to the first direction X. The third direction Z is the vertical direction and is orthogonal to both the first direction X and the second direction Y. The positive direction of the third direction Z is a vertical upward direction. The negative direction of the third direction Z is a vertical downward direction.

Note that the section illustrated in Fig. 1 is a section passing through the center of the inspection device 10 in the second direction Y along a direction perpendicular to the second direction Y.

First, the semiconductor device 500 being a device under test (DUT) of the inspection device 10 will be described by using Fig. 3.

Four antenna elements 510 are provided on the upper surface of the semiconductor device 500. The external shape of the antenna element 510 is a plate-shaped square, but the shape may be a plate-shaped circle or any other shape. The four antenna elements 510 are arranged in a square lattice with two rows and two columns to constitute an array antenna. The radio waves emitted from the semiconductor device 500 can be controlled by controlling conditions, such as amplitude and a phase, of the radio waves emitted from each antenna element 510. Note that the layout of the antenna elements 510 is not limited to the layout according to the present embodiment. For example, only one antenna element 510 may be provided on the upper surface of the semiconductor device 500. A plurality of antenna elements 510 may be arranged in a rectangular lattice. A plurality of antenna elements 510 may be arranged in one direction in one line. Alternatively, a plurality of antenna elements 510 may be arranged in a polygonal lattice such as a triangular lattice, a quadrilateral lattice, or a hexagonal lattice. Alternatively, a plurality of antenna elements 510 may be arranged in a circular ring or in an elliptical ring.

Next, the inspection device 10 will be described by using Fig. 1 and Fig. 2.

The inspection device 10 includes the holding portion 20 and an antenna portion 30. The holding portion 20 holds the semiconductor device 500. The holding portion 20 includes an inspection substrate 110, a socket 120, and a fixing portion 200. The antenna portion 30 inspects the semiconductor device 500.

The inspection substrate 110 is, for example, a PCB (Printed Circuit Board). The socket 120 is provided on the upper surface of the inspection substrate 110. The semiconductor device 500 is mounted on the upper surface of the inspection substrate 110 through the socket 120. The inspection substrate 110 and the semiconductor device 500 are electrically connected to each other through the socket 120. A signal input to the inspection substrate 110 is input to the semiconductor device 500 through the socket 120. A signal output from the semiconductor device 500 is output from the inspection substrate 110 through the socket 120.

The fixing portion 200 is, for example, formed of an insulating material such as resin. The fixing portion 200 presses (fixes) the semiconductor device 500 toward the inspection substrate 110. Specifically, the fixing portion 200 includes a pressing portion 202 in contact with an edge of the upper surface of the semiconductor device 500. By contacting the pressing portion 202 with the edge of the upper surface of the semiconductor device 500, the fixing portion 200 fixes the semiconductor device 500 to a predetermined position on the socket 120 and presses the semiconductor device 500 toward the socket 120. This secures contact between the semiconductor device 500 and the socket 120.

The fixing portion 200 defines a hole 210 exposing at least a portion of the semiconductor device 500, or more specifically, at least a portion of the upper surface of the semiconductor device 500. The radio waves emitted from the antenna element 510 provided on the upper surface of the semiconductor device 500 reach the antenna portion 30 through the hole 210. The radio waves emitted from the antenna portion 30 reach the antenna element 510 provided on the upper surface of the semiconductor device 500 through the hole 210.

The antenna portion 30 performs OTA(Over-the-Air) inspection of the semiconductor device 500. The antenna portion 30 is placed above the semiconductor device 500. The antenna portion 30 at least one of transmits the radio waves emitted to the semiconductor device 500 and receives the radio waves emitted from the semiconductor device 500. Specifically, the antenna portion 30 is electrically connected to an unillustrated external measuring instrument. The radio waves are emitted from the antenna portion 30 toward the semiconductor device 500, based on a signal input from the external measuring instrument to the antenna portion 30. A signal is output from the antenna portion 30 toward the external measuring instrument, based on the radio waves emitted from the semiconductor device 500 toward the antenna portion 30.

Next, details of the hole 210 in the fixing portion 200 will be described by using Fig. 1 and Fig. 2.

At least a portion of the inside surface of the hole 210 has a staircase shape in the third direction Z and includes a step portion. Specifically, the inside surface of the hole 210 includes a plurality of horizontal planes 212 and a plurality of vertical planes 214 forming the staircase shape. As viewed from the depth direction of the hole 210, that is, the third direction Z, the plurality of horizontal planes 212 are placed concentrically with respect to the center of the hole 210. The position of each of the plurality of horizontal planes 212 in the third direction Z is higher further away from the center of the hole 210. According to the present embodiment, a portion of the inside surface of the hole 210 from the bottom of the hole 210, that is, the lower end of the hole 210 on the negative direction side of the third direction Z, to the opening of the hole 210, that is, the upper end of the hole 210 on the positive direction side of the third direction Z has a fourstep staircase shape. Note that the layout of the staircase shape and the number of stair steps in the staircase shape are not limited to the example according to the present embodiment. For example, as viewed from the depth direction of the hole 210, the plurality of horizontal planes 212 may be placed unconcentrically with respect to the center of the hole 210. The number of stair steps in the staircase shape may be at least one, for example.

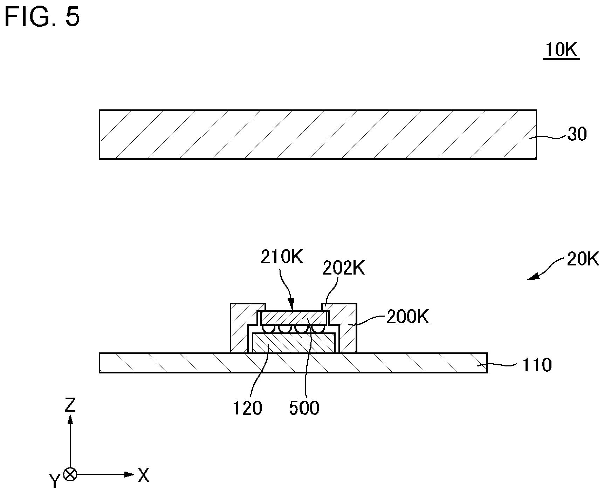

The radio waves emitted from the semiconductor device 500 may be scattered by the pressing portion 202 of the fixing portion 200. As more components of the radio waves scattered by the pressing portion 202 travels in the vertical direction in a space above the semiconductor device 500, the distortion occurring in an emission pattern of the radio waves of the semiconductor device 500 may increase. According to the present embodiment, the components of the radio waves scattered by the pressing portion 202 and traveling in the vertical direction in the space above the semiconductor device 500 can be reduced compared with a case of the inside surface a hole 210K being flat along the third direction Z as illustrated in Fig. 5 to be described later. That is, according to the present embodiment, the radio waves traveling in the fixing portion 200 and scattered at both ends of the vertical plane 214 can be canceled each other when a longitudinal dimension (a dimension in the third direction Z) Δv of each stair step in the staircase shape of the inside surface of the hole 210 is an appropriate distance according to an inspection frequency of the semiconductor device 500. This can reduce the components of the radio waves scattered by the pressing portion 202 and traveling in the vertical direction in the space above the semiconductor device 500, to facilitate traveling of the radio waves in the horizontal direction in the fixing portion 200, compared with the case of the inside surface of the hole 210K being flat along the third direction Z as illustrated in Fig. 5 to be described later.

According to the present embodiment, as viewed from the depth direction of the hole 210, the layout of the staircase shape of the inside surface of the hole 210 is substantially similar to a shape constructed by joining virtual straight lines between the layout of the plurality of antenna elements 510 provided on the semiconductor device 500. In other words, according to the present embodiment, as viewed from the third direction Z, the layout of the plurality of horizontal planes 212 in the hole 210 is substantially similar to a shape constructed by joining virtual straight lines between the plurality of antenna elements 510. In this case, the radio waves scattered at both ends of the horizontal plane 212 can be canceled each other when a lateral dimension Δh of each stair step in the staircase shape of the inside surface of the hole 210 is an appropriate distance according to the inspection frequency of the semiconductor device 500. Accordingly, the radio waves scattered by the inside surface of the hole 210 in the fixing portion 200 can be destructive, compared with a case of the layout of the staircase shape of the inside surface of the hole 210 not being similar to the layout of the plurality of antenna elements 510 as viewed from the third direction Z. Note that the layout of the staircase shape of the inside surface of the hole 210 may not be similar to the layout of the plurality of antenna elements 510 as viewed from the third direction Z, as long as the lateral dimension Δh is an appropriate value to provide the above effect.

Fig. 4 is a diagram for illustrating details of an example of the staircase shape of the inside surface of the hole 210 in the fixing portion 200. Fig. 4 does not illustrate the inspection substrate 110 and the antenna portion 30 that are illustrated in Fig. 1. In Fig. 4, an electric field distribution Eh represents an electric field distribution formed by the radio waves traveling outward in the fixing portion 200 from the center of the hole 210 in the horizontal direction. An electric field distribution Ev represents an electric field distribution formed by the radio waves traveling upward in the space above the semiconductor device 500 from the semiconductor device 500 in the vertical direction.

The longitudinal dimension Δv of each stair step in the staircase shape of the inside surface of the hole 210 may be about (2N - 1)/4 times, such as equal to or greater than (2N - 1)/4 - 1/16 times and equal to or less than (2N - 1)/4 + 1/16 times a wavelength λ/(εᵣ)^{1/2} in the fixing portion 200 of the radio wave having the inspection frequency of the semiconductor device 500. Note that λ denotes the wavelength of the inspection frequency of the semiconductor device 500, εᵣ denotes the relative dielectric constant of the fixing portion 200, and N denotes an integer equal to or greater than 1. For example, when the inspection frequency of the semiconductor device 500 is 28.5 GHz, εᵣ = 3.44, and N = 1, the longitudinal dimension Δv may be about 1.42 mm.

The lateral dimension Δh of each stair step in the staircase shape of the inside surface of the hole 210 may be about (2M - 1)/4 times, such as equal to or greater than (2M - 1)/4 - 1/16 times and equal to or less than (2M - 1)/4 + 1/16 times a wavelength λ in the air of the radio wave having the inspection frequency of the semiconductor device 500. Note that λ denotes the wavelength of the inspection frequency of the semiconductor device 500 and M denotes an integer equal to or greater than 1. For example, when the inspection frequency of the semiconductor device 500 is 28.5 GHz, and M = 1, the lateral dimension Δh may be about 2.63 mm.

When the longitudinal dimension Δv is (2N - 1)/4 times λ/(εᵣ)^{1/2}, can be more easily separated from the radio waves that are emitted from the semiconductor device 500 without being scattered by the pressing portion 202 and travels upward in the space above the semiconductor device 500 from the semiconductor device 500 in the vertical direction, compared with a case of the longitudinal dimension Δv being different from (2N - 1)/4 times λ/(εᵣ)^{1/2}.

Specifically, at least some of the radio waves emitted from the semiconductor device 500 and traveling in the fixing portion 200 from the pressing portion 202 become radio waves at a wavelength λ/(εᵣ)^{1/2} traveling in the fixing portion 200 outward from the center of the hole 210 in the horizontal direction. Some of the radio waves branch upward in the fixing portion 200 at each stair step in the staircase shape of the inside surface of the hole 210 and is reflected downward in the fixing portion 200 by the horizontal plane 212. The radio waves traveling upward in the fixing portion 200 at each stair step in the staircase shape of the inside surface of the hole 210 and the radio waves reflected by the horizontal plane 212 and traveling downward in the fixing portion 200 can be canceled each other when the longitudinal dimension Δv is (2N - 1)/4 times λ/(εᵣ)^{1/2}. For this reason, when the longitudinal dimension Δv is (2N - 1)/4 times λ/(εᵣ)^{1/2}, the radio waves emitted from the semiconductor device 500 and traveling in the fixing portion 200 can travel more easily in the horizontal direction than in the vertical direction.

When the lateral dimension Δh is (2M - 1)/4 times λ, the components of the radio waves emitted from the semiconductor device 500 and scattered at an interface between the inside surface of the hole 210 and the air in contact with the inside surface can be more easily separated from the radio waves directly travelling upward in the space above the semiconductor device 500 from the semiconductor device 500 in the vertical direction, compared with a case of the lateral dimension Δh being different from (2M - 1)/4 times λ.

Specifically, at least some of the radio waves emitted from the semiconductor device 500 and traveling along the interface between the inside surface of the hole 210 in the fixing portion 200 and the air in contact with the inside surface are scattered at both ends of the horizontal plane 212. The radio waves scattered at both ends of the horizontal plane 212 are canceled each other when the lateral dimension Δh is (2M - 1)/4 times λ. For this reason, when the lateral dimension Δh is (2M - 1)/4 times λ, the radio waves emitted from the semiconductor device 500 and scattered at the interface between the inside surface of the hole 210 and the air in contact with the inside surface can less easily travel in the vertical direction, compared with a case of the lateral dimension Δh being different from (2M - 1)/4 times X.

Fig. 5 is a cross-sectional view of an inspection device 10K according to a comparative example. The inspection device 10K according to the comparative example is similar to the inspection device 10 according to the embodiment except for the following points.

By contacting a pressing portion 202K with an edge of the upper surface of a semiconductor device 500, a fixing portion 200K in the inspection device 10K according to the comparative example fixes the semiconductor device 500 to a predetermined position on a socket 120 and presses the semiconductor device 500 toward the socket 120. The inside surface of the hole 210K in a fixing portion 200K in the inspection device 10K according to the comparative example is flat along the third direction Z.

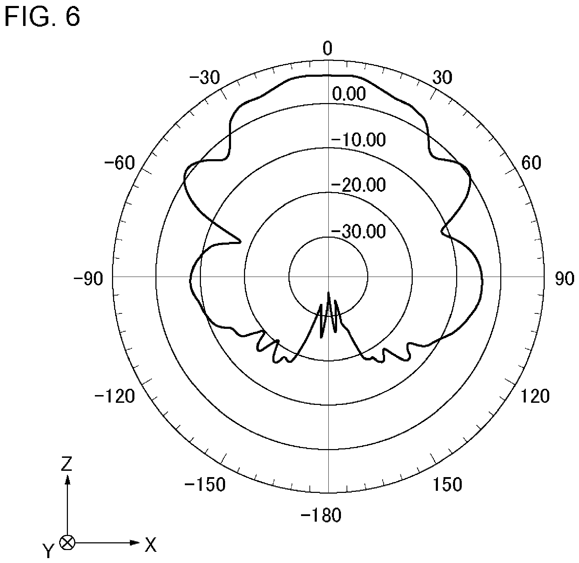

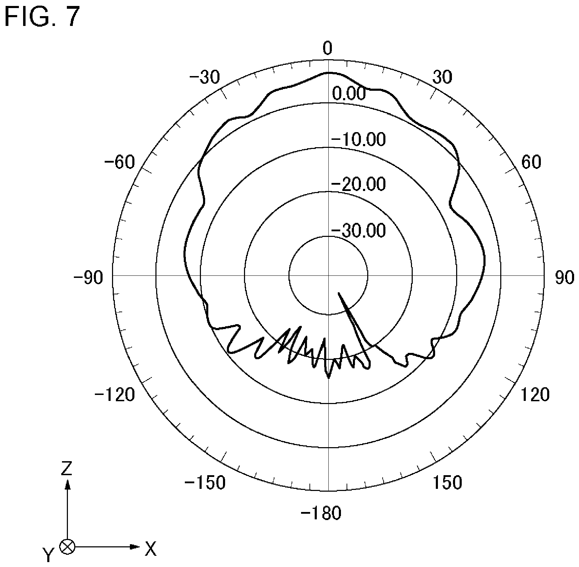

Fig. 6 is a diagram illustrating an emission pattern of the radio waves of the semiconductor device 500 in the inspection device 10 according to the embodiment. Fig. 7 is a diagram illustrating an emission pattern of the radio waves of the semiconductor device 500 in the inspection device 10K according to the comparative example. In Fig. 6 and Fig. 7, numbers given outside a graduated circle denote direction (unit: degrees) of an emission pattern. Numbers given from the center of the circle in a 0 degree direction indicate gains (unit: dBi). The 0 degree direction of an emission pattern, that is, a boresight direction is the positive direction of the third direction Z.

The emission pattern according to the comparative example includes ripples in about ±15 degrees directions as illustrated in Fig. 7. On the other hand, the gain is almost constant from the 0 degree direction to about the ±15 degrees directions in the emission pattern according to the embodiment, as illustrated in Fig. 6. The result suggests that the staircase shape of the inside surface of the hole 210 in the fixing portion 200 reduces distortion of the emission pattern of the semiconductor device 500.

While the embodiments of the present invention have been described above with reference to the drawings, the embodiments are exemplifications of the present invention, and various configurations other than those described above may be employed.

While these operations have been described regarding the work when the radio waves are emitted from the semiconductor device 500, similar effects are acquired when the radio waves emitted from the antenna portion 30 are received by the semiconductor device 500 except that the traveling direction of the radio waves becomes a reverse direction.

The specification provides the following aspects.

### (Aspect 1)

An aspect 1 is an inspection device including:
a fixing portion fixing a device under test; and
an antenna portion inspecting the device under test, wherein
the fixing portion defines a hole exposing at least a portion of the device under test, and
at least a portion of an inside surface of the hole in the fixing portion includes a step portion.

The aspect 1 can reduce the components of the radio waves scattered by the fixing portion and traveling from the device under test toward the antenna portion in a space between the device under test and the antenna portion, to facilitate traveling of the radio waves outward from the center of the hole in the fixing portion, compared with a case of the inside surface of the hole being flat along the depth direction of the hole. Accordingly, the aspect 1 can reduce distortion in an emission pattern of the radio waves of the device under test, compared with the case of the inside surface of the hole being flat along the depth direction of the hole.

### (Aspect 2)

An aspect 2 is the inspection device according to the aspect 1, wherein
a longitudinal dimension of the step portion of the inside surface of the hole is equal to or greater than (2N - 1)/4 - 1/16 times and equal to or less than (2N - 1)/4 + 1/16 times a wavelength in the fixing portion of a radio wave having an inspection frequency of the device under test (N is an integer equal to or greater than 1) .

In the aspect 2, the radio waves emitted from the device under test and scattered by the fixing portion can be more easily separated from the radio waves emitted from the device under test and not scattered by the fixing portion and traveling from the device under test toward the antenna portion in the space between the device under test and the antenna portion, compared with a case of the longitudinal dimension being different from the above value.

### (Aspect 3)

An aspect 3 is the inspection device according to the aspect 1 or 2, wherein
a lateral dimension of the step portion of the inside surface of the hole is equal to or greater than (2M - 1)/4 - 1/16 times and equal to or less than (2M + 1)/4 + 1/16 times a wavelength in air of a radio wave having an inspection frequency of the device under test (M is an integer equal to or greater than 1).

In the aspect 3, the components of the radio waves emitted from the device under test and scattered at an interface between the inside surface of the hole and the air in contact with the inside surface can be more easily separated from the radio waves directly traveling in the space between the device under test and the antenna portion from the device under test toward the antenna portion, compared with a case of the lateral dimension being different from the above value.

### (Aspect 4)

An aspect 4 is the inspection device according to any one of the aspects 1 to 3, wherein,
as viewed from a depth direction of the hole, a layout of the step portion of the inside surface of the hole is substantially similar to a layout of a plurality of antenna elements provided in the device under test.

In the aspect 4, the radio waves scattered by the inside surface of the hole in the fixing portion can be destructive when the lateral dimension of the step portion of the inside surface of the hole is an appropriate distance according to the inspection frequency of the device under test, compared with a case of the layout of the step portion of the inside surface of the hole not being similar to the layout of the plurality of antenna elements as viewed from the depth direction of the hole.

This application claims priority based on Japanese Patent Application No. 2020-143159 filed on August 27, 2020, the entire disclosure of which is incorporated herein.

### REFERENCE SIGNS LIST

- 10: Inspection device
- 10K: Inspection device
- 20: Holding portion
- 30: Antenna portion
- 110: Inspection substrate
- 120: Socket
- 200: Fixing portion
- 200K: Fixing portion
- 202: Pressing portion
- 202K: Pressing portion
- 210: Hole
- 210K: Hole
- 212: Horizontal plane
- 214: Vertical plane
- 500: Semiconductor device
- 510: Antenna element
- Eh: Electric field distribution
- Ev: Electric field distribution
- X: First direction
- Y: Second direction
- Z: Third direction

## Claims

1. An inspection device comprising:
a fixing portion fixing a device under test; and
an antenna portion inspecting the device under test, wherein
the fixing portion defines a hole exposing at least a portion of the device under test, and
at least a portion of an inside surface of the hole in the fixing portion includes a step portion.

2. The inspection device according to claim 1, wherein
a longitudinal dimension of the step portion of the inside surface of the hole is equal to or greater than (2N - 1)/4 - 1/16 times and equal to or less than (2N - 1)/4 + 1/16 times a wavelength in the fixing portion of a radio wave having an inspection frequency of the device under test (N is an integer equal to or greater than 1).

3. The inspection device according to claim 1 or 2, wherein
a lateral dimension of the step portion of the inside surface of the hole is equal to or greater than (2M - 1)/4 - 1/16 times and equal to or less than (2M + 1)/4 + 1/16 times a wavelength in air of a radio wave having an inspection frequency of the device under test (M is an integer equal to or greater than 1).

4. The inspection device according to any one of claims 1 to 3, wherein,
as viewed from a depth direction of the hole, a layout of the step portion of the inside surface of the hole is substantially similar to a layout of a plurality of antenna elements provided in the device under test.
